Europäisches Patentamt

European Patent Office

Office européen des brevets

(19)

(11) Veröffentlichungsnummer : **0 131 145
B1**

(12) **EUROPÄISCHE PATENTSCHRIFT**

(45) Veröffentlichungstag der Patentschrift :
09.09.87

(51) Int. Cl.⁴ : **G 03 F   3/08**

(21) Anmeldenummer : **84106330.8**

(22) Anmeldetag : **02.06.84**

(54) **Mehrfarbendruck mit sieben bzw. acht Druckfarben und mit nebeneinanderliegenden Flächenelementen.**

(30) Priorität : **03.06.83 DE 3320141**

(43) Veröffentlichungstag der Anmeldung :
**16.01.85 Patentblatt 85/03**

(45) Bekanntmachung des Hinweises auf die Patenterteilung : **09.09.87 Patentblatt 87/37**

(84) Benannte Vertragsstaaten :
**CH DE FR GB IT LI NL SE**

(56) Entgegenhaltungen :
**DE-A- 1 771 422
DE-A- 2 307 374
GB-A- 1 001 433
GB-A- 2 106 741
US-A- 3 247 816**

(73) Patentinhaber : **Küppers, Harald
Im Buchenhain 1
D-6070 Langen (DE)**

(72) Erfinder : **Küppers, Harald
Im Buchenhain 1
D-6070 Langen (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Vorliegende Erfindung betrifft ein Reproduktionsverfahren zur Herstellung mehrfarbiger Drucke, bei dem der Farbeindruck durch eine Vielzahl von eingefärbten Flächenelementen entsteht.

Es ist in der Drucktechnik bekannt, mehrfarbige Drucke mit Hilfe von Farbauszügen herzustellen, wobei für jede Druckfarbe ein Farbauszug hergestellt und die Reproduktion durch Übereinanderdruck der durch die Farbauszüge erstellten Teilbilder hergestellt wird. Üblicherweise werden drei bunte Druckfarben, Magenta (M), Cyan (C) und Gelb (Y) bzw. beim Vierfarbendruck zusätzlich noch die Farbe Schwarz (S) verwendet. Diesem Druckverfahren liegen einerseits das Gesetz der subtraktiven Mischung und andererseits das Gesetz der optischen Mischung (additive Mischung) zugrunde. Durch das Gesetz der subtraktiven Mischung entstehen durch Übereinanderdruck lasierender Farbschichten die Sekundär- und Tertiärfarben der verschiedenen Flächenelemente, wobei Flächenelemente in den Farben Gelb, Magentarot, Cyanblau, Orangerot, Grün, Violettblau und Schwarz gebildet werden. Durch die nicht mit Druckfarbe bedeckten Papierstellen entstehen die Flächenelemente in Weiß. Durch Übereinanderdruck von jeweils zwei lasierenden bunten Farbschichten entstehen die Sekundärfarben Orangerot, Grün und Violettblau. Durch Übereinanderdruck der drei bunten Farbschichten entstehen Flächenelemente in Schwarz. Durch die Druckfarbe Schwarz kommen ebenfalls Flächenelemente in Schwarz hinzu.

Die Herstellung solcher Farbauszüge erfolgt mittels sogenannter Scanner, wozu beispielsweise auf die DE-B-21 07 738 verwiesen wird. Solche Geräte sind seit längerem im kommerziellen Einsatz, so z. B. der Scanner, Type DC 300 oder der Scanner Chromagraph CTX 330 der Firma Dr.-Ing. Rudolf Hell GmbH, Kiel. Der Scanner Chromagraph CTX 330 ist in der Druckschrift Nr. 1483 (T-Id-8201) vom Januar 1982 der Firma Dr.-Ing. RUdolf Hell GmbH, Kiel, beschrieben. Solche Scanner arbeiten beispielsweise mit einer Laserschreibeinheit zur Erzeugung der Rasterpunkte, wobei die Rasterpunktkonfigurationen gespeichert sind und bei der Aufzeichnung mit Hilfe dieser gespeicherten Daten die Laserschreibeinheit angesteuert wird.

In der DE-A-32 03 972 und in der DE-A-30 37 774 ist weiterhin ein Verfahren zur Darstellung von mehrfarbigen Bildern angegeben, bei dem ein Farbauftrag mittels Tintenstrahl derart erfolgt, daß einzelne Flächenelemente eingefärbt werden, indem mit den Druckfarben M, G, C, Y Farbtropfen in einer Matrix abgelagert werden. Hierbei wird bei niedrigen Tonwerten ebenfalls mit additiver Mischung (optische Mischung) und bei hohen Tonwerten mit subtraktiver Mischung gearbeitet.

Diese Druckverfahren sind sehr verbreitet, sind aber mit Nachteilen behaftet, so z. B. treten beim Druck Farbannahmeprobleme auf, bei nicht exaktem Einhalten der Rasterwinkelung erscheint Moiré, und reine und leuchtende Farben lassen sich nicht gut reproduzieren.

Der vorliegenden Erfindung liegt daher die Aufgabe zugrunde, ein neues Reproduktionsverfahren zur Herstellung mehrfarbiger Drucke anzugeben, das völlig unanfällig gegen Moiré ist und mit dem eine verbesserte Farbreproduktion ermöglicht wird. Die Erfindung erreicht dies durch die im kennzeichnenden Teil des Anspruchs 1 angegebenen Merkmale. Vorteilhafte Weiterbildungen der Erfindung sind in den Unteransprüchen 2 bis 6 beschrieben. Das erfindungsgemäße Verfahren zeichnet sich dadurch aus, daß mit sieben bzw. acht Druckfarben gearbeitet wird und die druckenden Elemente nebeneinander liegen, wobei die Fläche eines gedruckten mehrfarbigen Bildes in gleich große geometrische Teilflächen zerlegt wird, z. B. Quadrate, Rechtecke, gleichseitige Dreiecke, Sechsecke oder Rhomben, und wobei die Größe der einzelnen Teilflächen so gewählt wird, daß sie bei dem jeweiligen Betrachtungsabstand unter der Auflösungsschwelle des menschlichen Auges liegen, so daß die einzelnen Teilflächen nicht einzeln erkannt werden. Wenn auf weißen oder transparenten Bedruckstoff gedruckt wird, wird mit sieben Druckfarben gearbeitet, nämlich Gelb, Orangerot, Magentarot, Violettblau, Cyanblau, Grün und Schwarz, wenn auf Bedruckstoffen mit einer beliebigen Farbe gedruckt wird, so wird Weiß durch die achte Druckfarbe Weiß gedruckt.

Die einzelnen geometrischen Teilflächen werden durch maximal vier nebeneinanderliegende Flächenelemente ausgefüllt. Wenn vier Flächenelemente in einer Teilfläche vorhanden sind, handelt es sich um Flächenelemente der Farben Weiß und Schwarz einerseits und um Flächenelemente von zwei benachbarten (nebeneinanderliegenden) bunten Druckfarben andererseits.

In diesem Druckverfahren entsteht der Buntanteil einer Farbnuance (Bildstelle) durch zwei der sechs genannten benachbarten bunten Druckfarben. Der Buntanteil kann also entstehen durch die bunten Druckfarben Gelb und Orangerot oder Orangerot und Magentarot oder Magentarot und Violettblau oder Violettblau und Cyanblau oder Cyanblau und Grün oder Grün und Gelb. Der Unbuntanteil einer Farbnuance (Bildstelle) entsteht immer durch die Farben Schwarz und Weiß, sei es, daß das Flächenelement von Weiß dadurch entsteht, daß unbedruckter Bedruckstoff wirksam bleibt oder daß weiße Flächenelemente durch die Druckfarbe Weiß auf den Bedruckstoff gedruckt werden.

Bei der Anwendung des Verfahrens auf weißem oder transparentem Bedruckstoff kann wahlweise mit lasierenden (also transparenten) Farben oder mit deckenden (opaken) Druckfarben gearbeitet werden. Bei einem Bedruckstoff mit anderer Färbung kommt grundsätzlich die Druckfarbe Weiß als deckende Farbe hinzu. Beim Drucken auf einem irgendwie anders gefärbten Bedruckstoff wird grundsätzlich mit deckenden Druckfarben gearbeitet, wobei ebenfalls als achte Druckfarbe Weiß hinzukommt.

Die Erfindung wird im folgenden anhand der Figuren 1-7 näher erläutert. Es zeigen :

Figur 1   eine Tabelle für die Beziehungen zwischen den bei der Erfindung verwendeten Druckfarben (Grundfarben) und den extremen bunten Farbempfindungen des menschlichen Sehorgans (Urfarben),

Figur 2   eine Tabelle der verschiedenen Buntarten in Verbindung mit den Empfindungskräften des menschlichen Sehorgans,

Figur 3   eine Darstellung der maximalen Potentiale der Farbempfindungen des menschlichen Auges,

Figur 4a   ein Beispiel für eine Farbnuance, die durch verschiedene Farbempfindungspotentiale entsteht,

Figur 4b   eine Darstellung für die Ableitung der prozentualen Farbflächen des Beispiels der Figur 4a,

Figur 4c   eine flächige Darstellung der prozentualen Farbflächen in einer Teilfläche gemäß dem Beispiel der Figur 4a,

Figur 5a ein Beispiel für eine andere Farbnuance,

Figur 5b eine Darstellung der Ableitung der prozentualen Farbflächen gemäß dem Beispiel der Figur 5a,

Figur 5c   eine flächige Darstellung der prozentualen Farbflächen in einer Teilfläche gemäß dem Beispiel der Figur 5a,

Figur 6   eine Aufteilung der Bildfläche in Flächenelemente und Teilflächen für den erfindungsgemäßen Druck,

Figuren 6a-6d   Darstellungen einzelner Farbauszüge für das Beispiel der Figur 6,

Figur 7   eine Einrichtung zur Durchführung des Verfahrens,

Figur 7a   ein Beispiel für die Aufzeichnung eines Flächenelementes mit einem Mehrfachschreiborgan und

Figur 8   ein Schaltungsbeispiel zur Ermittlung der Farbanteile der einzelnen Teilflächen.

Zum Verständnis der vorliegenden Erfindung wird im folgenden auf die Funktion des menschlichen Sehorgans eingegangen. Es wird in diesem Zusammenhang auf das Buch, Das Grundgesetz der Farbenlehre, Harald Küppers, DuMont-Buchverlag, Köln, 1980, verwiesen.

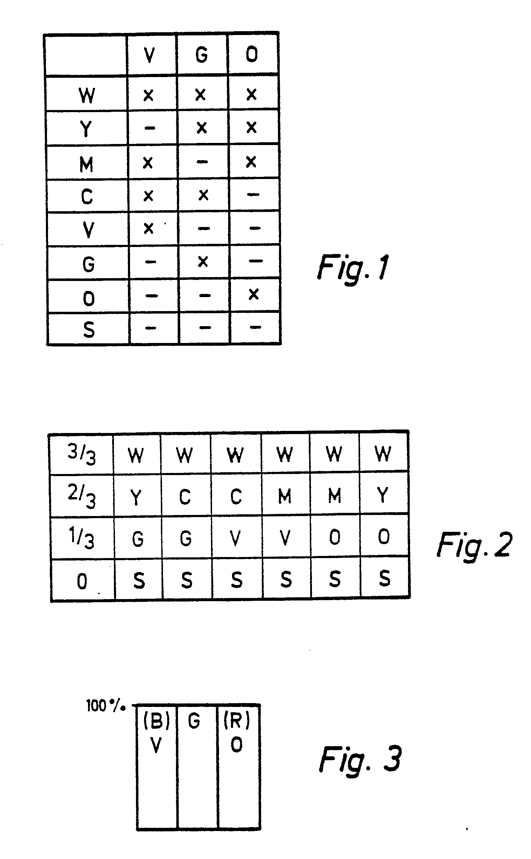

Das Sehorgan vermag aufgrund seiner drei auf verschiedenen Lichtwellenlängen empfindlichen Sehzellentypen (Zäpfchen), drei sogenannte Urfarben, Violettblau, Grün und Orangerot, und durch seine Stäbchen unterschiedliche Helligkeitswerte wahrzunehmen. Den drei Komponenten der Urfarben entsprechen acht Grundfarben, was in Figur 1 anhand einer Tabelle dargestellt ist. Die unbunten Grundfarben sind Weiß (W) und Schwarz (S), die bunten Grundfarben sind Gelb (Y), Magentarot (M), Cyanblau (C), Violettblau (V), Grün (G) und Orangerot (O). In der Tabelle der Figur 1 ist durch Kreuze und Striche markiert, welche der drei Farben Violettblau, Grün und Orangerot bei den entsprechenden Grundfarben beteiligt sind.

Figur 2 zeigt die einzelnen Kombinationsmöglichkeiten, YG ; CG ; CV ; MV ; MO ; und YO, woraus ersichtlich ist, daß die Buntarten sich jeweils aus zwei Grundfarben und die Unbuntarten aus Weiß und Schwarz ergeben.

Figur 3 zeigt, wie Farbempfindung durch die drei Komponenten dargestellt werden kann, wobei ein Kennzeichnungszahlensystem für die drei Komponenten derart eingeführt wird, daß der jeweilige maximale Empfindungswert mit 100 % und der minimale Empfindungswert mit 0 % angesetzt wird. Das Zusammenspiel der drei Komponenten, d. h. die jeweilige Teilmenge der entsprechenden Farbe ergibt die resultierende Farbnuance F. Wie hieraus zu ersehen ist, gibt es so viele Farbempfindungen, wie es quantitative Variationsmöglichkeiten der Urfarben gibt.

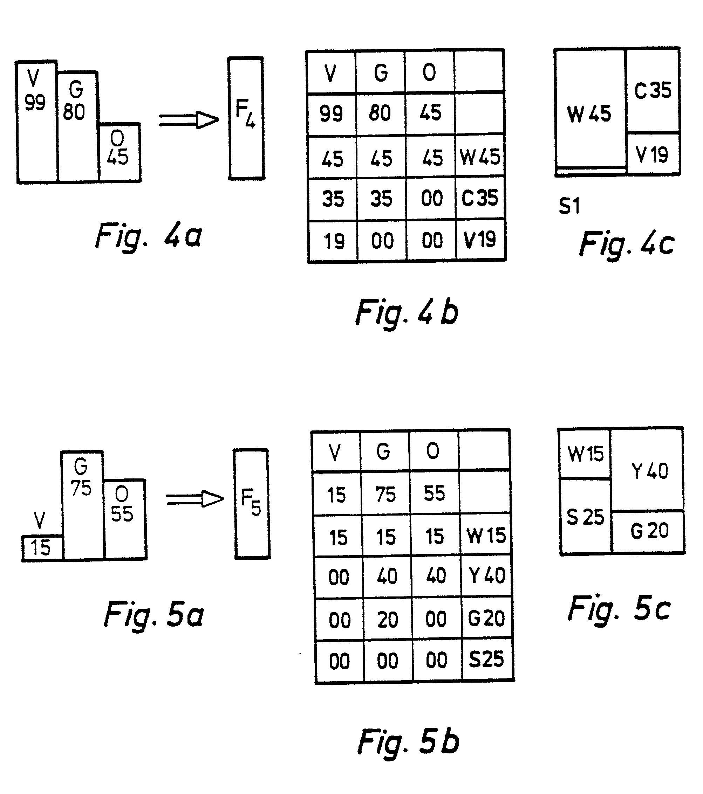

Im Beispiel der Figur 4a ist das Zustandekommen einer Farbnuance $F_4$ dargestellt, die aus folgenden Komponenten besteht :

$$V = 99 \%$$
$$G = 80 \%$$
$$O = 45 \%$$

Die Figur 5a zeigt das Zustandekommen einer Farbnuance $F_5$, die aus folgenden Komponenten besteht :

$$V = 15 \%$$
$$G = 75 \%$$
$$O = 55 \%$$

Wie aus dem Vorangegangenen zu ersehen ist, können auf diese Art und Weise alle beliebigen Farbnuancen erzielt werden.

Dieses Prinzip der sogenannten integralen Farbmischung macht sich das erfindungsgemäße Druckverfahren zu Nutze.

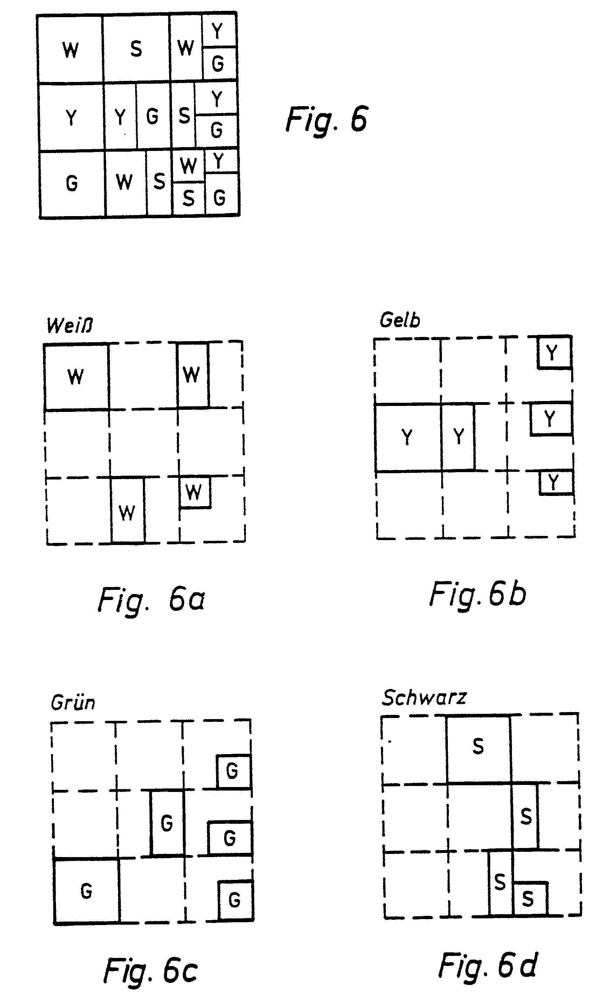

Das Druckverfahren wird im folgenden anhand der Figuren 6 und 6a bis 6d näher erläutert. Figur 6 zeigt einen Bildausschnitt bzw. einen Ausschnitt aus einem Druckprodukt, welches aus einer Vielzahl von Flächenelementen aufgebaut ist, die nach dem Prinzip der integrierten Farbmischung mit einzelnen Teilflächen der acht Grundfarben ausgefüllt sind. Bei den Feldern in der linken Spalte und bei dem

3

oberen Feld in der mittleren Spalte handelt es sich um die Grundfarben Gelb und Grün, bei dem Flächenelement in der Mitte um einen Nebeneinanderdruck von zwei Grundfarben Gelb und Grün und bei dem Flächenelement Mitte unten um ein unbuntes Flächenelement, das aus entsprechenden Anteilen von Weiß und Schwarz aufgebaut ist. Das Feld oben rechts repräsentiert eine verweißlichte reine Farbe (klare Farbe), das Feld rechts Mitte eine verweißlichte reine Farbe (dunkel, klare Farbe) und das Feld rechts unten Farbe, die aus einem Unbuntanteil und einem Buntanteil besteht.

Die Figuren 6a bis 6d zeigen, wie bei diesem Beispiel die einzelnen Farbauszüge für die Farben Weiß, Gelb Grün und Schwarz aufgebaut sind, wobei leicht zu ersehen ist, daß ein Zusammendruck wieder das in Figur 6 wiedergegebene Muster ergibt.

Um zu erläutern, wie die einzelnen Teilfarbenmengen ermittelt werden, wird nochmals auf die Beispiele der Figuren 4a und 5a zurückgegriffen. Der Farbeindruck, d. h. die Farbnuance $F_4$ ist in Figur 4a durch V = 99 %, G = 80 % und 0 = 45 % bestimmt. In Figur 4b ist gezeigt, wie die einzelnen Teilfarbmengen der Grundfarben ermittelt werden. Allen drei Urfarben ist in diesem Beispiel der Faktor 45 gemeinsam, was den unbunten Anteil Weiß darstellt. Dies ergibt sich durch einen Vergleich mit der Tabelle der Figur 1, in der in der ersten Zeile alle drei Urfarben V, G und O vorliegen. Den verbleibenden Restfarben V und G ist die Farbmenge 35 % gemeinsam, und aus der Tabelle der Figur 1 ergibt sich, daß die gemeinsame Grundfarbe Cyanblau vorliegt. Cyanblau ist also bei dieser Farbnuance mit 35 % vertreten, was in Spalte 4 der Zeile 4a dargestellt ist. Es verbleiben dann noch für die Farben Violettblau allein 19 % und für die Schwarzfarbe 1 %, was zu vernachlässigen ist.

Für das Beispiel der Figur 5a ergibt sich laut Spalte 3 der Figur 5b eine gemeinsame Weißmenge von 15 %. Grün und Orangerot haben die Farbmengen 40 % gemeinsam, was gemäß Tabelle der Figur 1 die gemeinsame Grundfarbe Gelb ergibt. Es verbleibt noch nach Abzug von 40 % Gelb für die Farbe Grün eine Farbmenge von 20 % und ein Rest an Schwarzfarbe von 25 %. Es ergibt sich eine Farbnuance, wie sie in Figure 5c dargestellt ist und die etwa der Fläche 9 in der Figur 5b entspricht.

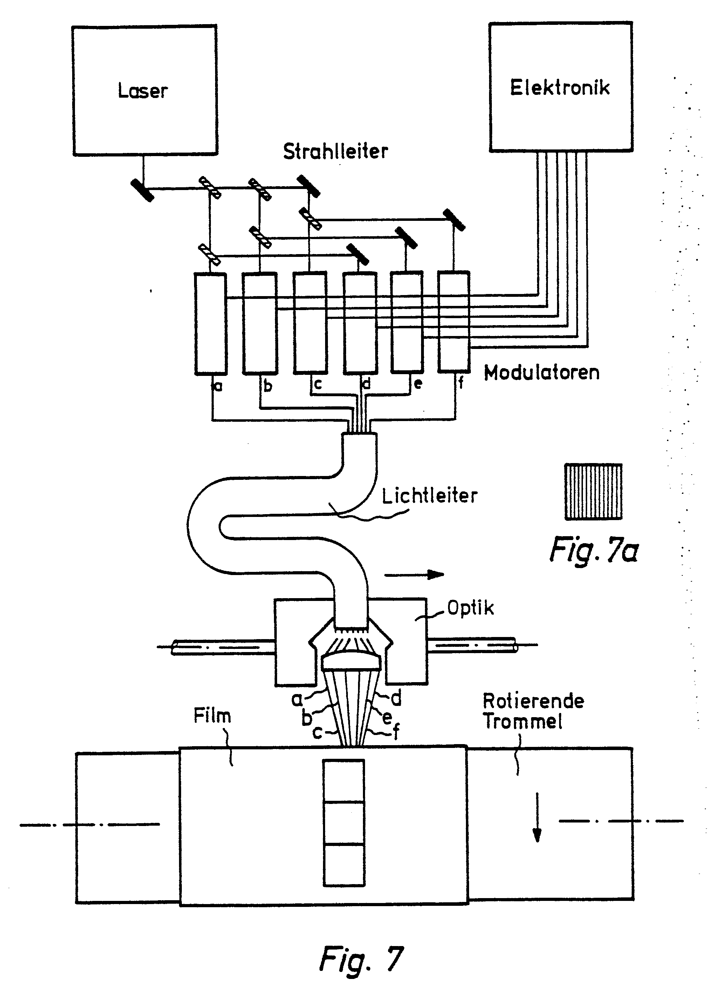

Figur 7 zeigt eine Einrichtung zur Aufzeichnung der Farbauszüge, wie sie in den Figuren 6a bis 6d dargestellt sind, wozu beispielsweise die Aufzeichnungseinheit eines Laserscanners, z. B. des eingangs erwähnten Gerätes CTX 330 oder eine Aufzeichnungseinheit, wie sie in der DE-B-21 07 738 beschrieben ist, verwendet werden kann. Ein Lichtstrahl wird im Beispiel der Figur 7 über einen Strahlteiler, der aus einem System von Spiegeln besteht, in sechs Teilstrahlen aufgespalten, und die Teilstrahlen werden über Modulatoren, welche über eine elektronische Steuerschaltung einzeln angesteuert werden, auf das Aufzeichnungsmedium gegeben. Die Ausgangsstrahlen der Modulatoren sind über Lichtleiterkabel und eine Optik auf das Aufzeichnungsmedium gerichtet, im vorliegenden Falle auf ein an Film, der auf einer rotierenden Trommel aufgespannt ist. Je nachdem zu welchem Zeitpunkt die Modulatoren eingeschaltet werden, ergeben sich Belichtungsmuster, wie sie schematisch auf dem Film angedeutet sind. Figur 7a zeigt in vergrößertem Maßstab den Aufbau solcher Teilflächen. Betrachtet man die Farbauszüge der Figuren 6a bis 6d und würde z. B. ein Farbauszug, z. B. der Farbauszug 6a aufgeschrieben, so werden die Modulatoren nur an den Stellen eingeschaltet, an denen die entsprechende Druckfarbe Weiß vorhanden ist.

Die Aufzeichnung dieser Teilflächen kann selbstverständlich auch durch direkten Farbauftrag, wie z. B. mit einem farbtüchtigen Ink Jet-Druckkopf erfolgen, wozu bei geeigneter Ansteuerung Ink Jet-Drucker, wie sie z. B. in den eingangs genannten beiden deutschen Offenlegungsschriften, DE-A-32 03 972 und DE-A-30 37 774 angegeben sind, verwendet werden können. Bei Aufzeichnung mit einer Laserschreibeinheit gemäß Figur 7, werden in vorteilhafter Weise die Punktmeßmuster vorher digital gespeichert, was z. B. in der DE-PS 21 07 738 für einzelne Rasterpunkte beschrieben ist. Gemäß der vorliegenden Erfindung könnte aber in einfacher Weise der gesamte Farbauszug, so wie in den Figuren 6a bis 6d dargestellt ist, abgespeichert werden, so daß die Ansteuerung der Laserschreibeinheit durch direktes Auslesen der digitalen Information, ob gedruckt werden soll oder nicht, aus den jeweiligen Farbauszugsspeichern erfolgen kann.

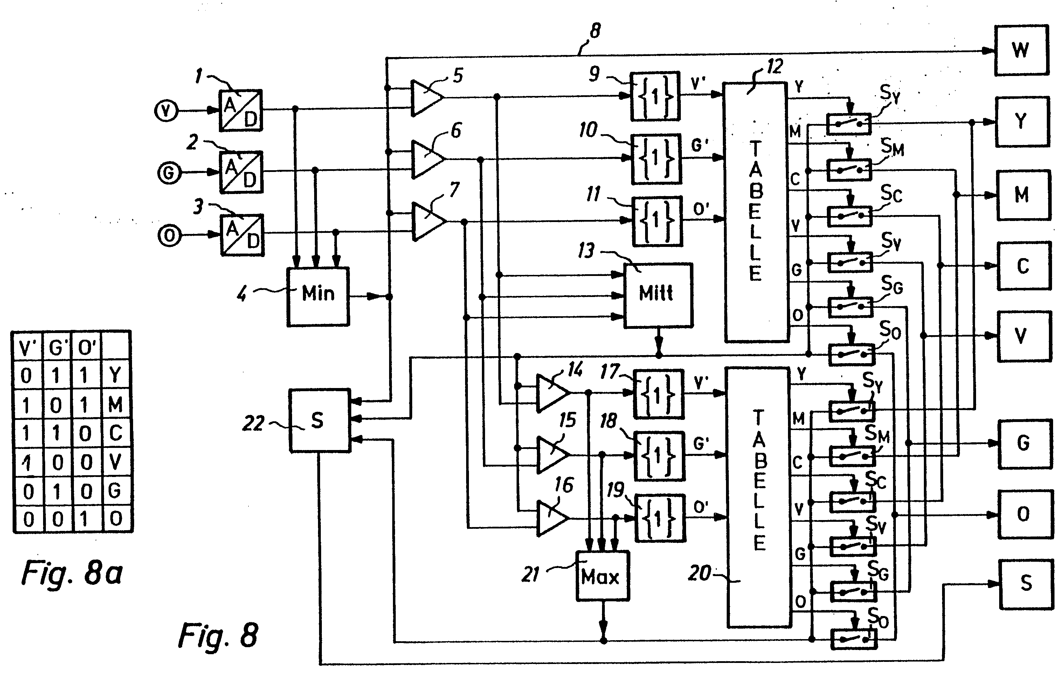

Der Schaltung der Figur 8 zur Erzeugung der Farbauszüge für das erfindungsgemäße Verfahren liegt ein normaler Farbabtaster zugrunde, der über eine trichromatische Abtastung von einem Original die Farbkomponenten Violettblau, Grün und Orangerot durch optischelektrische Wandlung bereitstellt. Solche Abtaster sind allgemein bekannt und auch Bestandteil der eingangs genannten Farbscanner, so daß die Abtasteinheit im einzelnen nicht näher beschrieben wird, sondern von den durch die Fotowandler gelieferten trichromatischen Farbsignale ausgegangen wird.

Die Farbkomponenten Violettblau, Grün und Orangerot werden auf Analogdigitalwandler 1, 2 und 3 gegeben, an deren Ausgang eine Minimumauswahlstufe 4 angeschlossen ist. Diese Stufe liefert an ihrem Ausgang das kleinste der drei Farbkomponenten signale, welches dann in Subtrahierern 5, 6 und 7, die an die Analog-Digitalwandler und an den Ausgang der Minimumstufe angeschlossen sind von den einzelnen Farbkomponenten subtrahiert wird.

Das kleinste Signal, das am Ausgang der Minimumstufe auftritt, stellt den Prozentsatz des weißen Farbanteils dar, der allen drei Komponenten gemeinsam ist und wird über eine Leitung 8 in einen Farbauszugsspeicher W eingeschrieben. Die dort abgelegte Information entspricht dem prozentualen Weißwert an der betreffenden Bildstelle, an der vom Abtaster die Farbkomponenten V, G und O gewonnen wurden.

Die Ausgänge der Subtrahierer 5, 6 und 7 werden auf Beschränkungsstufen 9, 10 und 11 gegeben, in denen die Ausgangssignale, falls sie größer oder gleich 1 sind, auf 1 beschränkt werden und wenn sie kleiner 1 sind, als 0 interpretiert werden. Diese Signale V', G' und O' werden an den Eingang eines Tabellenspeichers 12 gegeben, für den in Figur 8 a eine Wahrheitstabelle angegeben ist, die der Zuordnung der Urfarben zu den 6 bunten Grundfarben der Figur 1 entspricht. Anstelle der Striche in Figur 1 wurde 0 gesetzt und anstelle der Kreuze eine binäre 1. Am Ausgang des Tabellenspeichers erscheint dann je nach der in der Tabelle angegebenen Eingangskombination V' G' O' eine der bunten Grundfarben Y, M, C, V, G oder O. Durch diesen Vorgang ist identifiziert, welche der sechs bunten Grundfarben in der betreffenden Bildstelle, die vom Abtaster gesehen wird, vorwiegend enthalten ist. Im Beispiel der Figur 4a wäre dies laut der Tabelle in Figur 4b die bunte Grundfarbe Cyanblau und im Beispiel der Figur 5a gemäß der Tabelle in Figur 5b die bunte Grundfarbe Gelb.

Am Ausgang der Subtrahierer 5, 6 und 7 ist eine Stufe 13 angeschlossen, welche aus den drei Differenzsignalen das mittlere Signal aussucht. Da durch die erste Differenzbildung eines der am Ausgang der Stufen 5, 6 und 7 auftretenden Signale 0 ist, so ist das mittlere Signal grundsätzlich das kleinere der beiden verbleibenden Signale, so daß die Stufe 13 als einfache Stufe zur Detektion des kleineren Signals ausgebildet ist. Dieses Signal stellt den Prozentsatz der am Ausgang des Tabellenspeichers 12 erscheinenden bunten Grundfarbe dar, im Beispiel der Figur 4a für Cyan 35 % und im Beispiel der Figur 5a für Gelb 40 %.

Weiterhin sind am Ausgang der Subtrahierer 5, 6 und 7 weitere Subtrahierer 14, 15 und 16 vorgesehen, in denen das von der Stufe 13 gelieferte mittlere Differenzsignal von den aus den Stufen 5, 6 und 7 austretenden Differenzsignalen abgezogen wird. Diesen Subtrahierern 14, 15 und 16 sind weitere Beschränkungsstufen 17, 18 und 19 nachgeschaltet, für die die gleiche Bedingung wie für die Beschränkungsstufen 9, 10 und 11 gilt, nämlich daß alle Signale, die Z1 sind, als 1 interpretiert werden und daß alle Signale, die kleiner 1 sind, als 0 interpretiert werden. Diese Signale werden wiederum auf einen Tabellenspeicher 20 gegeben, der dieselbe Tabelle wie der Speicher 12 enthält. Am Ausgang dieses Tabellenspeichers erscheint wiederum nach der Wahrheitstabelle gemäß Figur 8 a ein buntes Grundfarbensignal, im Fall der Figur 4a wird die Farbe Violett blau signalisiert und im Fall der Figur 5a die Farbe grün. Die Ausgänge der Subtrahierer 14, 15 und 16 sind mit einer Maximumauswahlstufe verbunden, welche den prozentualen Farbanteil der im Ausgang des Speichers 20 erscheinenden bunten Grundfarbe angibt. Es gilt gemäß Figur 4c bzw. 4b der Wert 19 % für Violettblau und gemäß Figur 5 bzw. 5b der Wert 20 % für Gelb.

Da für jede unbunte und jede bunte der 6 bunten Farben ein Farbauszug erstellt werden soll, so ist für jeden dieser Farbauszüge ein Speicher vorgesehen, in Figur 8 jeweils mit den Abkürzungen für die betreffenden Farben bezeichnet. Die Farbauszugssignale der 6 bunten Druckfarben werden über Schalter zu den entsprechenden Farbauszugsspeichern weitergeleitet. Die Ausgänge der Mittelwertschaltung 13 und der Maximalwertschaltung 21 sind jeweils für 6 Schalter mit den 6 Farbauszugsspeichern für die 6 bunten Grundfarben verbunden. Die Betätigung der Schalter erfolgt durch die Ausgangssignale der Tabellenspeicher 12 und 20, d. h. wenn beim Speicher 12 am Ausgang eine Farbe erscheint, so wird der betreffende Prozentwert dieser Farben über den Schalter an den betreffenden Farbauszugsspeicher weitergeschaltet. Hierzu sind an dem Ausgang der Stufe 13 sechs Schalter, SY, SM, SC, SV, SG und SO angeschlossen, die mit den betreffenden Signalausgangsleitungen Y, M, C, V, G, S des Tabellenspeichers 12 eingeschaltet werden. Der Ausgang der Maximumstufe 21 und die Signalleitungen des Tabellenspeichers 20 sind ebenfalls über sechs solcher Schalter, die der Figur die gleiche Bezeichnung tragen, verknüpft und die Ausgänge jeweils 2 gleicher Schalter sind an den Eingang des betreffenden Farbauszugsspeicher durchgeschaltet. Um die Prozentzahl der Farbe Schwarz zu ermitteln, werden die Prozentzahlen des Weißwertes, des Mittelwertes und des Maximalwertes addiert und von 100 % abgezogen. Dies erfolgt in einer Stufe 22, welche mit dem Ausgang der Minimumstufe, der Mittelwertstufe und der Maximumwertstufe verbunden ist. Das Ausgangssignal diese Stufe wird an den Farbauszugsspeicher für die Farbe Schwarz weitergeleitet.

Für einen abgetasteten Bildpunkt der die Werte V, G und O liefert können also maximal 4 Farbwerte ermittelt werden, nämlich Weiß, eine der sechs bunten Grundfarben im Tabellenspeicher 12, eine der sechs bunten Grundfarben im Tabellenspeicher 20 und der Farbwert für die Farbe Schwarz. Hierbei ist es selbstverständlich möglich, wie eingangs beschrieben, daß einzelne dieser Werte 0 sind bzw. jeden beliebigen Wert zwischen 0 und 100 % annehmen können. Die Umsetzung dieser in den Farbauszugssignalen abgespeicherten Werte kann, wie bereits eingangs erwähnt, mittels einer Einrichtung gemäß der DE-B-21 07 738 erfolgen, indem für die einzelnen Prozentzahlen entsprechende Flächenelemente aufgezeichnet werden, wie sie z. B. in den Beispielen der Figuren 6a bis 6d für die Bildstelle, die in Figur 6 dargestellt worden ist, im einzelnen für die einzelnen Farbauszüge nochmals getrennt dargestellt worden sind. Die Farbauszugsspeicher der Figur 8 liefern z. B. die Eingangssignale für ein Adressenregister, das so aufgebaut sein kann, wie das in der DE-PS 21 07 738 in Figur 1 dargestellte Adressenregister 26 wobei die Größe der zu den einzelnen Prozentwerten gehörenden Flächenelemente vor der Reproduktion in Speicher eingegeben werden, wie er dem Speicher 23 der DE-PS entspricht. Da bei der vorliegenden Erfindung jeder einzelne Farbauszug separat mittels des Laserschre021organs hergestellt wird, werden nacheinander die Farbauszugsspeicher der Figur 8 an dieses Adressenregister geschaltet und von dem nachgeschalteten Speicher wird dann wie in der DE-PS angegeben, die Laseraufzeichnungseinrichtung wie sie auch in der Figur 7 der vorliegenden Patentanmeldung nochmals im einzelnen dargestellt ist, angesteuert. Die gefüllten Farbauszugsspeicher der Figur 8 ersetzen somit die Abtasteinheit in der DE-PS und liefern ebenfalls Prozentzahlen von 0 bis 100, mit denen an den betreffenden Bildstellen die entsprechenden Flächenelemente bzw. Teilflächen aufgezeichnet werden. Der eigentliche Druck erfolgt dann, indem die einzelne Farbauszüge nacheinander in verschiedenen Farbwerken auf dem Bedruckstoff übertragen werden. Wie aus der Figur 6 hervorgeht, kann die einzelne Teilfläche entweder von einer der 8 Farben allein ausgefüllt werden oder, wenn es sich um eine unbunte Farbnuance handelt, wird die Teilfläche durch Flächenelemente der beiden unbunten Farben Weiß und Schwarz ausgefüllt, und wenn es sich um eine reine bunte Farbnuance handelt, werden die Teilflächen von Flächenelementen von 2 nebeneinanderliegenden bunten Grundfarben ausgefüllt. Handelt es sich um Farbnuancen im Tertiärbereich, so können maximal in einer Teilfläche diese 4 Flächenelemente zusammen kommen, nämlich solche von den unbunten Farben Weiß und Schwarz einerseits und von 2 nebeneinanderliegenden bunten Druckfarben andererseits.

Gegenüber allen bisher bekannten Druckverfahren handelt es sich hier um eine Verfahrenstechnik, bei der an jeder Stelle des Bedruckstoffs nur höchstens eine Druckfarbschicht vorhanden sein kann, denn die Flächenelemente liegen grundsätzlich nebeneinander, was aus den Figuren 6 sowie 6a bis 6d hervorgeht. Dadurch ergeben sich für den Mehrfarbendruck folgende erhebliche Vorteile.

Da an jeder Stelle des Bedruckstoffs höchstens eine Farbschicht vorhanden ist, gibt es grundsätzlich keine Farbannahmeprobleme.

Da an jeder Stelle des Bedruckstoffs nur eine Farbschicht vorhanden ist, reduzieren sich die Trocknungsprobleme wesentlich, wodurch nicht nur die Dimensionierung der Trocknungsanlagen kleiner sein kann, sondern auch wesentlich weniger Energie für die Trocknung verbraucht werden muß.

Durch Verwendung von sechs bunten Druckfarben wird der reproduzierbare Farbenraum wesentlich erweitert. Es ist jetzt auch möglich, in den Farbbereichen Violett, Blau, Grün und Orangerot die reinsten und leuchtendsten Farben im Mehrfarbendruck hervorzubringen. Grund hierfür ist, daß sich die Farben nicht wie beim konventionellen Druck über die gesamte Bildfläche in Form von Rasterpunktstrukturen gegenseitig überlagern. Hierdurch wird auch ein völlig moiréfreies Druckbild ermöglicht. Es kann außerdem in sehr viel engeren Toleranzen gearbeitet werden als bei den bisherigen Druckverfahren, da Schwankungen der Einzeldruckfarben einen wesentlich geringeren Einfluß auf das Aussehen des Druckbildes haben. Auch ist es möglich, sehr viel schneller in der Druckmaschine zum gewünschten Druckergebnis zu kommen, wodurch Einrichtezeiten, d. h. Maschinenstunden und auch Makulatur eingespart werden können. Da auch deckende Farben verwendet werden können, ist die Farbe des Bedruckstoffs für das Auswählen des gedruckten Farbbildes bedeutungslos. Daraus ergibt sich auch der Vorteil, daß man auf minderwertigen Bedruckstoffen wie z. B. Tageszeitungspapier hochwertige mehrfarbig gedruckte Bilder entstehen lassen kann (z. B. für Anzeigen).

**Patentansprüche**

1. Reproduktionsverfahren zur Herstellung mehrfarbiger Drucke, bei denen der Farbeindruck durch eine Vielzahl von eingefärbten Flächenelementen entsteht, dadurch gekennzeichnet, daß die Bildfläche in gleich große, unter dem Auflösungsvermögen des menschlichen Auges liegende Teilflächen zerlegt wird, daß jede Teilfläche jeweils nach der hervorzubringenden Farbnuance der betreffenden Bildstelle in nebeneinanderliegende Flächenelemente zerlegt wird, die einen Buntanteil und einen Unbuntanteil bilden, wobei die Flächenelemente, die den Buntanteil bilden, je nach dem zu erzeugenden Buntanteil mit maximal zwei von sechs bunten Druckfarben Gelb, Orangerot, Magentarot, Violettblau, Cyanblau, Grün anteilmäßig bedruckt werden, und die Flächenelemente, die den Unbuntanteil bilden, je nach dem zu erzeugenden Unbuntanteil anteilmäßig Weiß und Schwarz sind.

2. Verfahren nach Anspruch 1, dadurch gekennzeichnet, daß eine Teilfläche in maximal vier Flächenelemente zerlegt wird, von denen zwei je nach Buntanteil der Teilfläche mit maximal zwei benachbarten Druckfarben Gelb und Orangerot oder Orangerot und Magentarot oder Magentarot und Violettblau oder Violettblau und Cyanblau oder Cyanblau und Grün oder Grün und Gelb bedruckt werden und zwei je nach dem zu erzielenden Unbuntanteil der Teilfläche anteilig mit Weiß bzw. Schwarz gefüllt werden.

3. Verfahren nach Anspruch 1 oder 2, dadurch gekennzeichnet, daß bei buntem Bedruckstoff der Weißanteil des Unbuntanteils durch Drucken mit der Farbe Weiß erzeugt wird.

4. Verfahren nach Anspruch 1 oder 2, dadurch gekennzeichnet, daß bei weißem Bedruckstoff oder Transparentmaterial der Weißanteil des Unbuntanteils durch Nichtbedrucken des Bedruckstoffes erzielt wird.

5. Verfahren nach einem der Ansprüche 1, 2 oder 4, dadurch gekennzeichnet, daß bei weißem Bedruckstoff mit transparenten (lasierenden) oder deckenden (opaken), Druckfarben gearbeitet wird.

6. Verfahren nach einem der Ansprüche 1, 2 oder 3, dadurch gekennzeichnet, daß bei nicht weißem Bedruckstoff mit deckenden Druckfarben gearbeitet wird.

**Claims**

1. Reproduction process for the production of multicolour printed matter, in which the colour impression is engendered by a plurality of coloured areal elements, characterised in that the image area is divided into part areas of identical size amounting to less than the resolution capacity of the human eye, that each part area is in each case divided, as a function of the hue of the respective image portion in question to be emphasized, into mutually adjacent areal elements which form a coloured portion and a colourless portion, the areal elements forming the coloured portion being imprinted as a function of the coloured portion which is to be generated with at most two of six chromatic printing colours, being yellow, orange-red, magenta-red, violot-blue, cyan-blue,, green, in appropriate proportion, and the areal elements forming the colourless proportion being white and black in appropriate proportion as a function of the colourless portion which is to te generated.

2. Process according to claim 1, characterised in that a part area is divided into at most four areal elements, of which two are imprinted as a function of the coloured portion of the part area with at most two close printing colours, being yellow and orange-red, or orange-red and magenta-red, or magenta-red and violet-blue, or violet-blue and cyan-blue, or cyan-blue and green, or green and yellow, and two are portionally covered with white and black respectively as a function of the colourless portion of the part area which is to be obtained.

3. Process according to claim 1 or 2, characterised, in that in the case of a coloured imprinting substrate, the hite part of the colourless portion is generated by imprinting with the colour white.

4. Process according to claim 1 or 2, characterised in that in the case of white imprinting substrate or transparent material, the white part of the colourless portion is obtained by not printing the imprinting substance.

5. Process according to one of the claims 1, 2 or 4, characterised in that the case of white imprinting substrate, the operation is performed with transparent (transmissive) printing colours, or with covering (opaque) printing colours.

6. Process according to one of the claims 1, 2 or 3, characterised in that the operation is performed with covering printing colours in the case of a non-white imprinting substrate.

## Revendications

1. Procédé de reproduction pour réaliser des impressions polychromes, dans lesquelles l'impression en couleur est formée d'une multitude d'éléments superficiels colorés, procédé caractérisé en ce que la surface de l'image est décomposée en surfaces partielles de mêmes dimensions se situant en dessous des possibilités de résolution de l'œil humain, en ce que chaque surface partielle est respectivement décomposée, selon la nuance de couleur à faire ressortir des emplacements d'image concernés, en éléments superficiels contigus qui constituent une partie colorée et une partie non colorée, les éléments superficiels qui constituent la partie colorée étant respectivement imprimés par parties avec au maximum deux des six coloris d'encre d'impression jaune, rouge orangé, rouge magenta, bleu-violet, bleu cyan, et vert, et des éléments superficiels qui constituent la partie non colorée sont, selon la partie non colorée à obtenir, en partie blancs et en partie noirs.

2. Procédé selon la revendication 1, caractérisé en ce qu'une surface partielle est décomposée en un maximum de quatre éléments superficiels dont deux, selon la partie colorée de cette surface partielle, sont imprimés avec au maximum deux couleurs d'impression voisines, jaune et rouge-orangé, ou bien rouge-orangé et rouge-magenta, ou bien rouge-magenta et bleu-violet, ou bien bleu-violet et bleu-cyan ou bien bleu-cyan et vert, ou bien vert et jaune, tandis que deux sont remplis, selon la partie non colorée de la surface partielle à obtenir en partie avec du blanc ou avec du noir.

3. Procédé selon la revendication 1 ou 2, caractérisé en ce que, dans le cas d'un matériau d'impression colorée, la partie blanche de la partie non colorée est obtenue par impression avec la couleur blanche.

4. Procédé selon la revendication 1 ou 2, caractérisé en ce que, dans le cas d'un matériau d'impression blanc, ou bien d'un matériau transparent, la partie blanche de la partie non colorée, est obtenue par non-impression du matériau d'impression.

5. Procédé selon une des revendications 1, 2 ou 4, caractérisé en ce que dans le cas d'un matériau d'impression blanc, on travaille avec des couleurs d'impression transparentes (brillantes) ou bien couvrantes (opaques).

6. Procédé selon une des revendications 1, 2 ou 3, caractérisé en ce que, dans le cas d'un matériau d'impression non blanc, on travaille avec des couleurs d'impression couvrantes.

|   | V | G | O |
|---|---|---|---|
| W | x | x | x |
| Y | – | x | x |
| M | x | – | x |
| C | x | x | – |
| V | x | – | – |
| G | – | x | – |
| O | – | – | x |
| S | – | – | – |

*Fig.1*

| 3/3 | W | W | W | W | W | W |
|---|---|---|---|---|---|---|
| 2/3 | Y | C | C | M | M | Y |
| 1/3 | G | G | V | V | 0 | 0 |
| 0 | S | S | S | S | S | S |

*Fig. 2*

100% •

| (B) V | G | (R) O |
|---|---|---|

*Fig. 3*

## Fig. 4a

| V | G | O | |
|---|---|---|---|
| 99 | 80 | 45 | |
| 45 | 45 | 45 | W 45 |
| 35 | 35 | 00 | C 35 |
| 19 | 00 | 00 | V 19 |

**Fig. 4 b**

**Fig. 4c**

S1

## Fig. 5a

| V | G | O | |
|---|---|---|---|
| 15 | 75 | 55 | |
| 15 | 15 | 15 | W 15 |
| 00 | 40 | 40 | Y 40 |
| 00 | 20 | 00 | G 20 |
| 00 | 00 | 00 | S 25 |

**Fig. 5 b**

**Fig. 5c**

Fig. 6

Weiß

Fig. 6a

Gelb

Fig. 6b

Grün

Fig. 6c

Schwarz

Fig. 6d

Fig. 7a

Fig. 7

Fig. 8

Fig. 8a